(19) Europäisches Patentamt / European Patent Office / Office européen des brevets

(11) **EP 4 118 502 B1**

(12) **EUROPEAN PATENT SPECIFICATION**

(45) Date of publication and mention
of the grant of the patent:
**26.06.2024 Bulletin 2024/26**

(21) Application number: **20848999.7**

(22) Date of filing: **25.12.2020**

(51) International Patent Classification (IPC):
**G05B 23/02** $^{(2006.01)}$

(52) Cooperative Patent Classification (CPC):
**G05B 23/0221; G05B 2219/24065**

(86) International application number:
**PCT/JP2020/049309**

(87) International publication number:
**WO 2021/181844 (16.09.2021 Gazette 2021/37)**

(54) **SYSTEM AND METHOD OF FAULT DETECTION BASED ON ROBUST DAMPED SIGNAL DEMIXING**

SYSTEM UND VERFAHREN ZUR FEHLERERKENNUNG BASIEREND AUF EINER ROBUSTEN GEDÄMPFTEN SIGNALENTMISCHUNG

SYSTÈME ET PROCÉDÉ DE DÉTECTION DE DÉFAUT REPOSANT SUR LA SÉPARATION ROBUSTE D'UN SIGNAL AMORTI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.03.2020 US 202016812696**

(43) Date of publication of application:
**18.01.2023 Bulletin 2023/03**

(73) Proprietor: **Mitsubishi Electric Corporation**
**Tokyo 100-8310 (JP)**

(72) Inventors:
• **LIU, Dehong**
**Cambridge, Massachusetts 02139-1955 (US)**
• **XIE, Youye**
**Cambridge, Massachusetts 02139-1955 (US)**
• **MANSOUR, Hassan**
**Cambridge, Massachusetts 02139-1955 (US)**
• **BOUFOUNOS, Petros**
**Cambridge, Massachusetts 02139-1955 (US)**

(74) Representative: **Pfenning, Meinig & Partner mbB**
**Patent- und Rechtsanwälte**
**Theresienhöhe 11a**
**80339 München (DE)**

(56) References cited:
• **KANEMARU MAKOTO ET AL: "Bearing Fault Detection in Induction Machine Based on Stator Current Spectrum Monitoring", IEEJ JOURNAL OF INDUSTRY APPLICATIONS, [Online] vol. 7, no. 3, 1 May 2018 (2018-05-01), pages 282-288, XP055794791, ISSN: 2187-1094, DOI: 10.1541/ieejjia.7.282 Retrieved from the Internet: URL:https://www.jstage.jst.go.jp/article/i eejjia/7/3/7_282/_pdf/-char/en> [retrieved on 2021-04-13]**
• **SARKAR ET AL: "Using the Matrix Pencil Method to Estimate the Parameters of a Sum of Complex Exponentials", IEEE ANTENNAS AND PROPAGATION MAGAZINE, vol. 37, no. 1, 1 January 1995 (1995-01-01), page 48, XP055037741, ISSN: 1045-9243, DOI: 10.1109/74.370583**
• **CAI JIAN-FENG ET AL: "Robust recovery of complex exponential signals from random Gaussian projections via low rank Hankel matrix reconstruction", APPLIED AND COMPUTATIONAL HARMONIC ANALYSIS, ACADEMIC PRESS INC, US, vol. 41, no. 2, 2 March 2016 (2016-03-02), pages 470-490, XP029680713, ISSN: 1063-5203, DOI: 10.1016/J.ACHA.2016.02.003**

- **XIE YOUYE ET AL: "Robust Parameter Estimation of Contaminated Damped Exponentials", ICASSP 2020 - 2020 IEEE INTERNATIONAL CONFERENCE ON ACOUSTICS, SPEECH AND SIGNAL PROCESSING (ICASSP), IEEE, 4 May 2020 (2020-05-04), pages 5500-5504, XP033793170, DOI: 10.1109/ICASSP40776.2020.9053507 [retrieved on 2020-04-01]**

**Description**

[Technical Field]

The present invention relates, generally, to system and method of monitoring electric machines, and, more particularly, to system and method of fault detection in electric machines based on robust damped signal demixing.

[Background Art]

Electric machines are widely used in a variety of application areas such as power plants, manufacturing factories, home appliances, electric vehicles, and the like. Electric machines can experience a variety of faults such as bearing faults, broken rotor bar faults, and winding short-circuit faults. These faults may reduce the life cycle of electrical machines and even cause sudden catastrophic failure. For example, bearing faults can cause excessive vibrations and frictions when the electrical machine is running at high velocity. Therefore, there is a need to detect a fault in the electric machines to reduce the losses caused by such faults.

KANEMARU MAKOTO ET AL: "Bearing Fault Detection in Induction Machine Based on Stator Current Spectrum Monitoring" (IEEJ Journal of Industry Applications, vol. 7, n. 3, 1 May 2018, pages 282-288) is related to fault detection in induction machines based on stator current spectrum monitoring.

[Summary of Invention]

The present invention is set forth and characterized in the independent claims, while the dependent claims describe other characteristics of the invention.

Different techniques for fault detection that are employed at present include, but are not limited to, vibration and acoustic signal analysis, electromagnetic field monitoring, temperature measurement, infrared recognition, and stator current spectral analysis.

In order to on-line monitor electric machine operation and instantly detect faults, it is necessary to analyze time sequential signal (vibration or current signal) of rotating electric machines and extract characteristic fault signatures for further analysis. However, due to the noisy working environment and changing load of electric machines, the measured signals are typically a mix of normal operating signal, fault signal, spike interferences, transient signal due to sudden change of load or supply voltage, and white Gaussian noise. For example, the magnitude of fault signatures can vary at different loads even if the fault signatures in the stator current are already subtle. As a result, it can be difficult to distinguish fault signatures from the normal operation signal and noise.

In order to decompose signal and detect fault signatures, classical methods such as Fourier transform and Wavelet transform work well for static operations. While for electric machines working in transient state, these classical methods perform poorly in extracting the fault signature due to its changing magnitude.

The Hilbert-Huang transform(HHT) is another way to decompose a signal and to analyze components. The HHT uses the empirical mode decomposition (EMD) to decompose a signal into so-called intrinsic mode function (IMF) with a trend, and applies Hilbert spectral analysis (HSA) method to the IMFs to obtain instantaneous frequency data. The HHT method is designed to work well for data that is nonstationary and nonlinear. However, it is more like an empirical approach without theoretical guarantee.

Another technique of the fault signature detection is based on the compressive sensing. Such a technique is making use of the super-resolution property of compressive sensing techniques to extract fault signature in a very short time such that the electric machine can be assumed to operate at a steady condition in the short time.

According to an embodiment of the present invention, a method detects faults during an operation of an electric machine is provided. The method measures, in a time domain, a signal of a stator current powering the electric machine, wherein the measuring includes sampling the signal for a period of time during the operation of the induction motor with a sampling rate of at least twice of a fundamental frequency of the stator current; a processor for demixing, in a time domain, a set of damped signals with non-zero amplitudes, spike interference, and noise, such that the set of damped signals include a fundamental frequency of operating signal, one or more possible fault signals, and other harmonic damped signals, and determining, a fault signal corresponding to a potential fault according to the signal frequency and magnitude. The method detects a fault in the electric machine if the set of damped signals includes a fault characteristic frequency corresponding to a fault.

Some embodiments of the present invention can provide a system and a method suitable for performing a fault detection of an electric machine based on analysis the stator current powering the electric machine during the operation of the electric machine or the vibration signal of the electric machine. In such a manner, the fault detection can be performed continuously and concurrently with the operation of the electric machine, and without a need for restarting the electric machine.

Further, some embodiments of the present invention provide such a system and a method that can perform the fault detection by measuring noisy signal of the electric machine, where the electric machine may be interfered by spike interference and have changing load condition.

Some embodiments of the invention are based on recognitions that under fault conditions the resulting stator current powering the induction motor is a mix of damped exponential signals, white Gaussian noise and spike interference. This is because the stator current includes harmonics of a fundamental frequency of a power supply generating the stator current and fault frequency components caused by the fault. The spike interference is cause by changing load or working conditions or some other interferences.

Some embodiments of the invention are based on recognitions that parameter estimation of damped exponentials has been extensively studied in the noiseless setting. Well-established methods for solving this problem include the Prony's method, which contains a polynomial root finding operation, and the matrix pencil method, which forms a matrix pencil based on the input signal and solves a generalized eigenvalue problem. However, both methods are very sensitive to noise.

Some embodiments of the invention are based on recognitions that data preprocessing methods based on singular value decomposition (SVD) of a Hankel matrix have been proposed for the matrix pencil method and have been found superior for denoising if the noise is random Gaussian.

Some embodiments of the invention are based on recognitions that a Hankel matrix constructed of a sum of damped exponentials is low-rank.

Some embodiments of the invention are based on recognitions that Robust principle component analysis (RPCA) has been proved to be very effective in extracting a low-rank matrix from spike interference contaminated observation.

These recognitions lead to a realization that the combination of the demixing damped signals using a matrix pencil, RPCA, spike noise, and Gaussian noise enable reconstruction of the actual signal using sparsity-driven techniques to denoise a low-rank Hankel matrix for the matrix pencil method.

Accordingly, one embodiment of the invention discloses a method for detecting faults during an operation of an electric machine. The method includes measuring, in a time domain, a signal of a current powering the electric machine; demixing, a set of damped signals with non-zero amplitudes, spike interference, and noise, such that the set of damped signals include a fundamental frequency of operating signal, one or more possible fault signals, and other harmonic damped signals, and determining, a fault signal corresponding to a potential fault according to the signal frequency and magnitude.

The demixing includes forming, a Hankel matrix of time-domain measurements, denoising, using a convex robust parameter estimation (CRPE) or a non-convex robust parameter estimation (NRPE) method to denoise a Hankel matrix, analyzing, using a matrix pencil method on the denoised Hankel matrix to achieve parameters of damped signals. The steps of the method are performed by a processor.

Another embodiment discloses a system for operating an electric machine including a power supply for powering the electric machine with a stator current having a fundamental frequency; a sensor for measuring, in a time domain, a signal of a stator current powering the electric machine, wherein the measuring includes sampling the signal for a period of time during the operation of the induction motor with a sampling rate of at least twice of a fundamental frequency of the stator current; a processor for demixing, in a time domain, a set of damped signals with non-zero amplitudes, spike interference, and noise, such that the set of damped signals include a fundamental frequency of operating signal, one or more possible fault signals, and other harmonic damped signals, and determining, a fault signal corresponding to a potential fault according to the signal frequency and magnitude.

The presently disclosed embodiments will be further explained with reference to the attached drawings. The drawings shown are not necessarily to scale, with emphasis instead generally being placed upon illustrating the principles of the presently disclosed embodiments.

[Brief Description of Drawings]

[Fig. 1A]

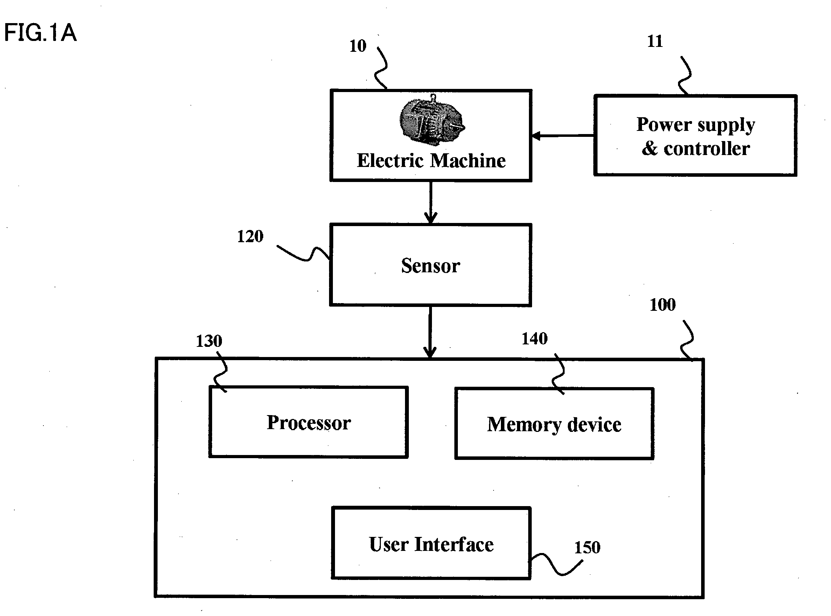

Figure 1A is a block diagram of a system for detection of faults in the electric machine during operation according to embodiments of the invention;
[Fig. 1B]

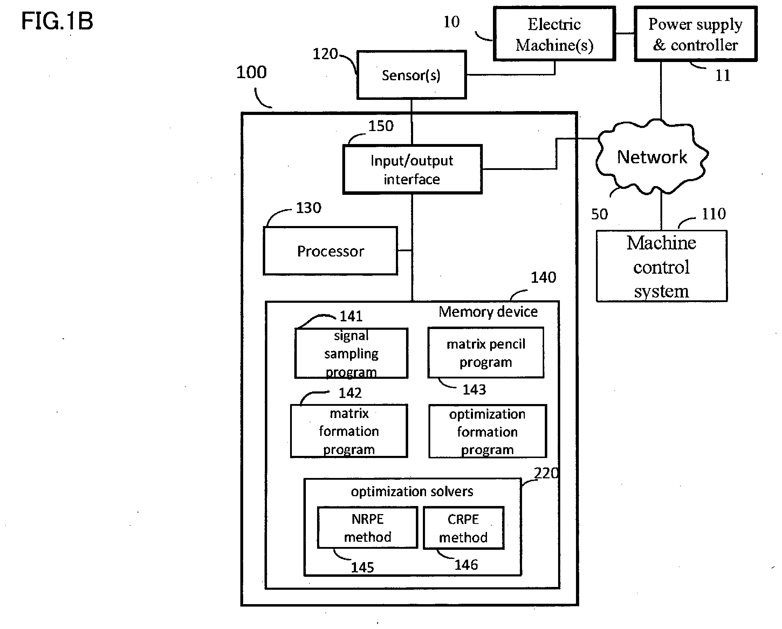

Figure 1B is a drawing for describing a system for detection of faults in the electric machine during operation according to embodiments of the invention;
[Fig. 2]

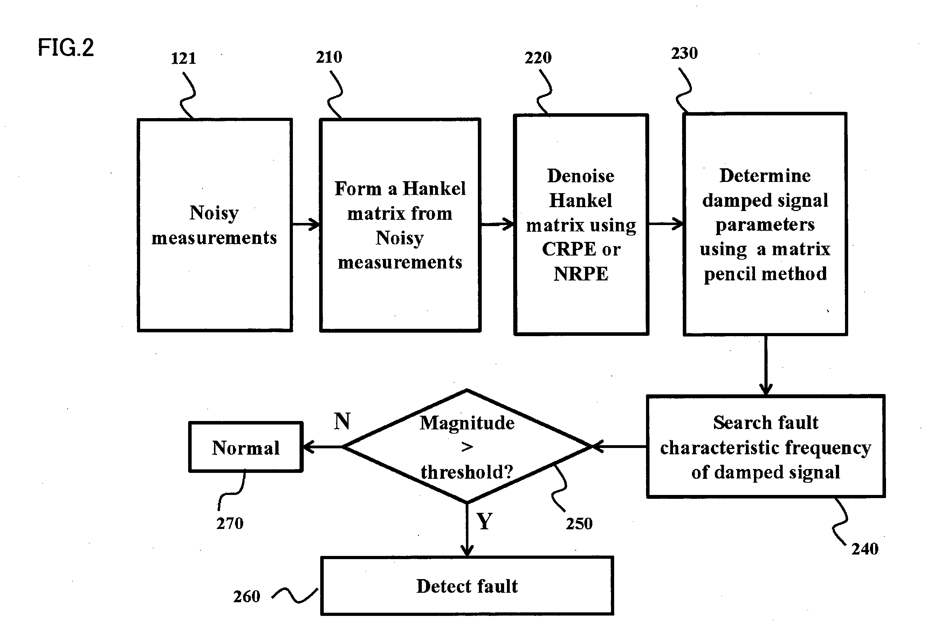

Figure 2 is a block diagram of a method for detecting the faults in the electric machine according to one embodiment of the invention;

[Fig. 3]

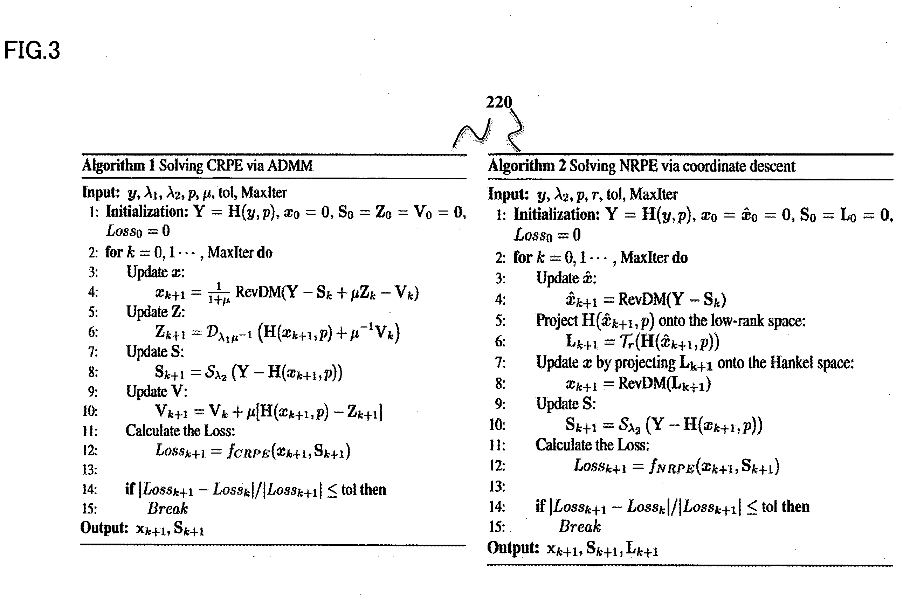

Figure 3 is a block diagram of a method for denoising the Hankel matrix of measurements according to another embodiment of the invention; and

[Fig. 4]

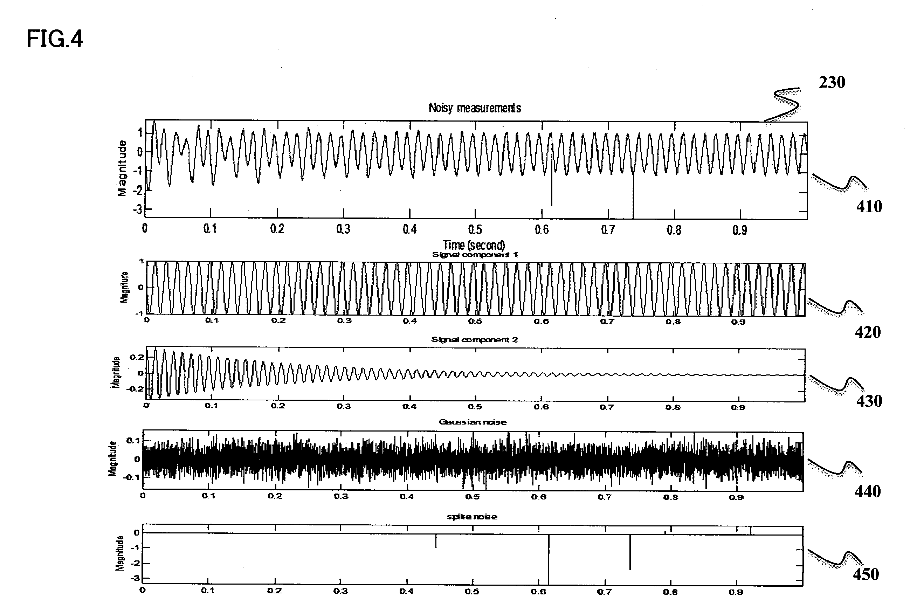

Figure 4 is exemplar plots of a signal of a stator current powering the electric machine and demixed damped signals including a fundamental operating frequency component, a fault signature damped signal, a Gaussian noise, and a spike interference.

While the above-identified drawings set forth presently disclosed embodiments, other embodiments are also contemplated, as noted in the discussion. This disclosure presents illustrative embodiments by way of representation and not limitation.

[Description of Embodiments]

The following description provides exemplary embodiments only, and is not intended to limit the scope, applicability, or configuration of the disclosure. Rather, the following description of the exemplary embodiments will provide those skilled in the art with an enabling description for implementing one or more exemplary embodiments.

Specific details are given in the following description to provide a thorough understanding of the embodiments. However, understood by one of ordinary skill in the art can be that the embodiments may be practiced without these specific details. For example, systems, processes, and other elements in the subject matter disclosed may be shown as components in block diagram form in order not to obscure the embodiments in unnecessary detail. In other instances, well-known processes, structures, and techniques may be shown without unnecessary detail in order to avoid obscuring the embodiments. Further, like reference numbers and designations in the various drawings indicated like elements.

Also, individual embodiments may be described as a process which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be rearranged. A process may be terminated when its operations are completed, but may have additional steps not discussed or included in a figure. Furthermore, not all operations in any particularly described process may occur in all embodiments. A process may correspond to a method, a function, a procedure, a subroutine, a subprogram, etc. When a process corresponds to a function, the function's termination can correspond to a return of the function to the calling function or the main function.

Furthermore, embodiments of the subject matter disclosed may be implemented, at least in part, either manually or automatically. Manual or automatic implementations may be executed, or at least assisted, through the use of machines, hardware, software, firmware, middleware, microcode, hardware description languages, or any combination thereof. When implemented in software, firmware, middleware or microcode, the program code or code segments to perform the necessary tasks may be stored in a machine readable medium. A processor(s) may perform the necessary tasks.

Figure 1A is a schematic of a system 100 for monitoring an exemplar electric machine according to one embodiment of an invention. In this example, the electric machine 10, which is operated via a power supply & controller 11, is asynchronized machine or synchronized machine with a rotating rotor and a fixed stator.

The system 100 includes a sensor (electrical signal sensors) 120 for measuring, in a time domain, a signal of a stator current powering the electric machine (or induction motor) 10. The measuring includes sampling the signal for a period of time during a steady state of the operation of the induction motor with a sampling rate of at least twice of a fundamental frequency of the stator current. According to certain embodiments, the electrical signal sensors 120 can be current or vibration sensors for acquiring current and vibration data pertaining to the electric machine 10. For example, the sensor 120 may be configured to sense current data from one or more of the multiple phases of the electric machine 10. More specifically, in the case of the electric machine is a 3-phase electric machine, the current and voltage sensors sense the current and voltage data from the three phases of the 3-phase electric machine. While certain embodiments of the present invention will be described with respect to a multi-phase electric machine, other embodiments of the present invention can be applied to other multi-phase electric machines.

A processor 130 is configured to determine, in a frequency domain, a set of frequencies with non-zero amplitudes, such that a reconstructed signal formed by the frequencies with non-zero amplitudes approximates the signal measured in the time domain. The determining includes searching within a subband including the fundamental frequency subject to condition of a sparsity of the signal in the frequency domain.

The system 100 also includes a memory device 140 for storing the measurements of the signal and various parameters and coefficients for performing signal analysis.

Figure 1B is a drawing for describing the system 100 for detection of faults in the electric machine during operation according to embodiments of the invention. The system 100 can also include an input/output interface 150 configured to acquire the signals from the sensor 120, and transmits signals(output data) to a machine control system 110 via a network 50 with respect to the fault, if the set of frequencies with non-zero amplitudes includes a frequency different from the dominant frequency. Further, the memory device 140 includes computer-executable programs for detecting faults of an electric machine. The computer-executable programs include a signal sampling program 141, a matrix formation program 142, a matrix pencil program 143, and optimization solvers 220 that are configured to perform non-convex robust parameter estimation (NRPE) method and a convex robust parameter estimation (CRPE) method using the processor 130. Accordingly, the processor 130 is configured, in response the signals from the sensor(s)120 via the I/O interface 150, to perform acquiring signals via sensors with respect to the machine for an input time domain, generating a signal matrix based on the acquired signals for the input time domain, forming an optimization problem with a low-rank constraint using a optimization formation program, demixing the signal matrix into a low-rank matrix, a spike interference matrix, and a Gaussian noise matrix by solving the optimization problem using one of optimization solvers, extracting parameters of damped exponentials from the low-rank matrix using the matrix pencil program, and determining the faults with respect to the induction machine by identifying each of the measured system parameters of the induction machine based on the lookup data. The procedures of the steps are described below.

Figure 2 shows a block diagram of a method for detecting faults during an operation of an electric machine according to one embodiment of the invention. The system 100 detects noisy measurements 121 of a signal of a stator current powering the induction motor measured by the sensor(s) 120 in a time domain to form a noisy Hankel matrix 210. The processor 130 of the system 100 is configured to denoise the noisy Hankel matrix using the CRPE method or non-convex robust parameter estimation (NRPE) method to generate a low-rank Hankel matrix corresponding to a setup of damped signals 220. A matrix pencil method 143 is then applied on the denoised Hankel matrix to determine damped signal parameters 230. The damped signal parameters are used to compare with fault characteristic frequency 240. If there exists a fault frequency and the magnitude is greater than a threshold 250, a corresponding fault is detected 260, otherwise the electric machine is running in normal condition 270.

For instance, the threshold 250 may be determined by the following. When there exists fault frequency component with magnitude greater than a certain value, for example, -30dB of the fundamental frequency component, and the fault frequency is close to the characteristic fault frequency, for example, within 5% of the characteristic fault frequency, the system 100 detects the fault in step 260. In this case, the characteristic fault frequency can be determined by mechanical structure of electric machine(for example, bearing size and number of balls) and the rotor speed. The greater the magnitude of the fault frequency, the more likely there is a fault, e.g., bearing inner race fault.

Mathematically, the system observes time domain signal

$$y(t) = \sum_{j=1}^{M} A_j e^{\alpha_j t} e^{i\left(2\pi f_j t + \theta_j\right)} + \eta(t) \quad , \quad (1)$$

where y(t) is the noisy observation consisting of a number of damped exponentials with their amplitude $A_j > 0$, damping coefficient $\alpha_j \le 0$, frequency $f_j > 0$, and phase $\theta_j \in R$, as well as their total number M, being unknown parameters. The noise $\eta(t)$ can be modeled as a mixture of Gaussian noise, g(t), and sparse spike interference, s(t), i.e., $\eta(t) = g(t) + s(t)$. In particular, s(t) can be either unwanted interference or a series of system responses with short response time compared to the sampling time, containing valuable information regarding the operating condition of the circuit or the electric machine.

The Hankel matrix $H_p(x) \in C^{(N-p) \times (p+1)}$ of a sampled signal $x \in C^N$, is defined as

$$\mathbf{H}_p(x) = \begin{bmatrix} x(1) & x(2) & \dots & x(p+1) \\ x(2) & x(3) & \dots & x(p+2) \\ \vdots & \vdots & & \vdots \\ x(N-p) & x(N-p+1) & \dots & x(N) \end{bmatrix}$$

If the sampled signal $x \in C^N$ is the sum of M damped exponentials, by choosing $p \in [M, N - M]$, the Hankel matrix generally becomes a matrix of rank $M \le p$, i.e., low-rank. In the noiseless case, the matrix pencil algorithm exploits this low-rank Hankel matrix to accurately estimate the exponentials parameters. Thus, in this work, we aim to extract such a low-rank Hankel matrix, $H_p(x)$, where x is the estimated sum of damped exponentials, using the observation Hankel matrix $Y = H_p(y) \in C^{(N-p)\times(p+1)}$, where $y \in C^N$ is the sampled noisy observation. In addition, we should be able to further extract a sparse matrix if spike interference exists. We rely on the assumption that M is small relative to N. Since p is fixed during the optimization process, we simplify notation using H(x) and dropping the subscript p. Inspired by the success of the robust principal component analysis and work in the compressive sensing community, we apply the nuclear norm to constrain the rank of H(x) and use the L1 norm to extract the sparse matrix S caused by the spike interference. We assume the residual represents the Gaussian noise. Combining those models results in the following convex robust parameter estimation (CRPE) problem

$$\min_{x,S} \frac{1}{2}||Y - H(x) - S||_2^2 + \lambda_1||H(x)||_* + \lambda_2||S||_1.$$

$$(2)$$

Alternatively, the non-convex robust parameter estimation (NRPE), replaces nuclear norm regularization with a rank constraint:

$$\min_{x,S} \frac{1}{2}||Y - H(x) - S||_2^2 + \lambda_2||S||_1$$

$$\text{subject to } \text{Rank}(H(x)) \leq r$$

$$(3)$$

where $r$ denotes the maximum number of damped exponentials we expect to recover. If we have a prior estimate or knowledge of the number of damped exponentials, based on the nature of the application, $r$ can be set greater than or equal to that estimate. Accordingly, some embodiments of the present invention are based on recognition that the NRPE optimization problem to be less sensitive to the hyper-parameters compared to the CRPE optimization problem. However, since (3) is non-convex, the optimization algorithm could get trapped in local minima.

To solve the CRPE optimization problem, we introduce an auxiliary variable Z and add the constraint H(x) = Z to (2). Then the augmented Lagrangian function of (2) becomes

$$\mathcal{L}_\mu(x, S, Z, V) = \frac{1}{2}||Y - H(x) - S||_2^2 + \lambda_1||Z||_*$$

$$+ \lambda_2||S||_1 + \langle H(x) - Z, V \rangle_R + \frac{\mu}{2}||H(x) - Z||_2^2,$$

where $V \in C^{(N-p)\times(p+1)}$ is the Lagrange multiplier matrix, $\mu$ is the penalty parameter associated with the augmented term, and $\langle A, B \rangle_R = Re(Tr(B^H A))$. Applying ADMM results in the update steps summarized in Algorithm 1 as shown in FIG. 3(a).

The Reverse Diagonal Mean operator (RevDM : $C^{(N-p)\times(p+1)} \mapsto C^N$) is defined as

$$\text{RevDM}(A) = \begin{bmatrix} A(1,1) \\ \frac{1}{2}[A(2,1) + A(1,2)] \\ \frac{1}{3}[A(3,1) + A(2,2) + A(1,3)] \\ \vdots \\ A(N-p, p+1) \end{bmatrix}$$

for A $\in$ $C^{(N-p)\times(p+1)}$ and A(i; j) is the entry of A in the i-th row and j-th column. $\mathcal{S}_\tau$(A) = sign(A)max{|A| - $\tau$,0} is the complex element-wise soft thresholding operator with threshold $\tau$, where sign(A) = A/|A| for the non-zero entry and 0 otherwise. max{·,·} is the element-wise maximum operator. Moreover, $\mathcal{D}_\tau$(A) = U diag(max{$\sigma$- $\tau$,0})W$^H$ is the singular value soft thresholding operator with threshold $\tau$, where the singular value decomposition of A = U diag($\sigma$)W$^H$ , $f_{CRPE}$ is the objective function of the CRPE optimization problem defined in (2).

The solver for the NRPE optimization problem, summarized in Algorithm 2, is based on the coordinate descent with projection. Tr(A) is the singular value truncation operator, which implements the singular value decomposition on the input matrix A and returns the matrix constructed using A's r largest singular values. $f_{NRPE}$ is the objective function of the NRPE optimization problem in (3). In the first experiment, we consider the bearing fault detection of the induction machine, where the machine current includes a 60Hz operating signal and a 90Hz sideband wave related to its rotational frequency component in the presence of Gaussian noise and spike interference. When a bearing fault or defect occurs, a damped frequency component in the current will be generated that depends on the fault location and the bearing size. For example, a 73Hz frequency component is caused by the cage defect of an outer ring. The magnitude of this defect frequency component is typically very small compared to the operating current signal, making bearing fault detection a very challenging problem. Still, its parameters, and sometimes the spike interference, are useful to evaluate the fault severity and operating condition of the machine.

The noisy fault observation is formulated as follows:

$$y(t) = e^{0t}1.0\cos(2\pi 60t + 1.3) + e^{-4.2t}0.1\cos(2\pi 73t + 0.2) + e^{-1.3t}0.3\cos(2\pi 90t + 1.7) + g(t) + s(t).$$

We observe 1 second of y with 1000 samples. The signal to Gaussian noise ratio is 25 dB and spike interference has 1% cardinality whose non-zero entries are randomly selected with magnitudes uniformly sampled in [0, 5]. We plot in Figure 4 an example signal of a stator current 410 powering the electric machine and demixed damped signals. Using a matrix pencil method on a denoised Hankel matrix, the noisy measurement is demixed into a fundamental operating frequency component 420, a fault signature damped signal 430, a Gaussian noise 440, and a spike interference 450.

The above-described embodiments of the present disclosure can be implemented in any of numerous ways. For example, the embodiments may be implemented using hardware, software or a combination thereof. When implemented in software, the software code can be executed on any suitable processor or collection of processors, whether provided in a single computer or distributed among multiple computers. Such processors may be implemented as integrated circuits, with one or more processors in an integrated circuit component. Though, a processor may be implemented using circuitry in any suitable format.

Also, the various methods or processes outlined herein may be coded as software that is executable on one or more processors that employ any one of a variety of operating systems or platforms. Additionally, such software may be written using any of a number of suitable programming languages and/or programming or scripting tools, and also may be compiled as executable machine language code or intermediate code that is executed on a framework or virtual machine. Typically, the functionality of the programs may be combined or distributed as desired in various embodiments. In some cases, computer-implemented programs used in the embodiments of the present invention may be referred to as program modules or modules.

Further, the embodiments of the present disclosure may be embodied as a method, of which an example has been provided. The acts performed as part of the method may be ordered in any suitable way. Accordingly, embodiments may be constructed in which acts are performed in an order different than illustrated, which may include performing some acts concurrently, even though shown as sequential acts in illustrative embodiments. Further, use of ordinal terms such as first, second, in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

**Claims**

1. A system for detecting faults of an electric machine during operation of the electric machine, comprising:

an interface configured to acquire signals via sensors with respect to the machine for an input time domain;

a memory to store computer-implemented programs including a signal sampling program, a matrix formation program, an optimization formation program, a matrix pencil program, optimization solvers and lookup data including predetermined system parameters related to the faults; and

a processor configured to perform the computer-implemented programs in connection with the interface and the memory, the system being **characterized in that** the processor in configured to perform:

generating a signal Hankel matrix based on the acquired signals for the input time domain;

forming an optimization problem with a low-rank constraint using the optimization formation program which generates a convex robust parameter estimation, CRPE, optimization problem or a non-convex robust parameter estimation, NRPE, optimization problem;

demixing the signal matrix into a low-rank matrix, a spike interference matrix, and a Gaussian noise matrix by solving the optimization problem using one of the optimization solvers;

extracting parameters of damped exponentials from the low-rank matrix using the matrix pencil program; and

determining the faults with respect to the electric machine by identifying each of measured system parameters of the electric machine based on the lookup data.

2. The system of claim 1, wherein the optimization solvers are based on a convex robust parameter estimation, CRPE, method and a non-convex robust parameter estimation, NRPE, method.

3. The system of claim 1, wherein the input time domain represents a sampling period and a sampling frequency.

4. The system of claim 1, wherein the matrix pencil program is configured to obtain eigenvalues and compute damping factor and frequency using the eigenvalues.

5. The system of claim 1, wherein the acquired signals are current signals or vibration signals based on operations of the electric machine.

6. The system of claim 1, wherein the electric machine is an electric circuit, an electric motor or an electric generator.

7. A method for detecting faults of an electric machine during operation of the electric machine, comprising:

acquiring signals via sensors with respect to the machine for an input time domain; the method being **characterized by**:

generating a signal Hankel matrix based on the acquired signals for the input time domain;

forming an optimization problem with a low-rank constraint using an optimization formation program which generates a convex robust parameter estimation, CRPE, optimization problem or a non-convex robust parameter estimation, NRPE, optimization problem;

demixing the signal matrix into a low-rank matrix, a spike interference matrix, and a Gaussian noise matrix by solving the optimization problem using one of optimization solvers;

extracting parameters of damped exponentials from the low-rank matrix using the matrix pencil program; and

determining the faults with respect to the electric machine by identifying each of measured system parameters of the electric machine based on the lookup data.

8. The method of claim 7, wherein the optimization solvers are based on a convex robust parameter estimation, CRPE, method and a non-convex robust parameter estimation, NRPE, method.

9. The method of claim 7, wherein the input time domain represents a sampling period and a sampling frequency.

10. The method of claim 7, wherein the matrix pencil program is configured to obtain eigenvalues and compute damping factor and frequency using the eigenvalues.

11. The method of claim 7, wherein the acquired signals are current signals or vibration signals based on operations of the electric machine.

12. The method of claim 7, wherein the electric machine is an electric circuit, an electric motor or an electric generator.

**Patentansprüche**

1. System zum Erfassen von Fehlern einer elektrischen Maschine während des Betriebs der elektrischen Maschine, umfassend:

   eine Schnittstelle, die eingerichtet ist, Signale über Sensoren in Bezug auf die Maschine für einen Eingangszeitbereich zu beschaffen;
   einen Speicher zum Speichern von computerimplementierten Programmen, aufweisend ein Signalabtastprogramm, ein Matrixbildungsprogramm, ein Optimierungsbildungsprogramm, ein Matrix-Pencil-Programm, Optimierungslöser und Nachschlagedaten, aufweisend vorbestimmte Systemparameter in Bezug auf die Fehler; und
   einen Prozessor, der eingerichtet ist, die computerimplementierten Programme in Verbindung mit der Schnittstelle und dem Speicher durchzuführen, wobei das System **dadurch gekennzeichnet ist, dass** der Prozessor eingerichtet ist, durchzuführen:

   Erzeugen einer Signal-Hankel-Matrix auf der Grundlage der beschafften Signale für den Eingangszeitbereich;
   Bilden eines Optimierungsproblems mit einer Low-Rank-Beschränkung unter Verwendung des Optimierungsbildungsprogramms, das ein Konvexe-Robuste-Parameter-Schätzung, CRPE, engl. convex robust parameter estimation, -Optimierungsproblem oder ein Nicht-Konvexe-Robuste-Parameter-Schätzung, NRPE, engl. non-convex robust parameter estimation, -Optimierungsproblem erzeugt;
   Entmischen der Signalmatrix in eine Low-Rank-Matrix, eine Spike-Interferenzmatrix und eine Gaußsche Rauschmatrix durch Lösen des Optimierungsproblems unter Verwendung eines der Optimierungslöser;
   Extrahieren von Parametern gedämpfter Exponentiale aus der Low-Rank-Matrix unter Verwendung des Matrix-Pencil-Programms; und
   Bestimmen der Fehler in Bezug auf die elektrische Maschine durch Identifizieren jedes gemessenen Systemparameters der elektrischen Maschine auf der Grundlage der Nachschlagedaten.

2. System nach Anspruch 1, wobei die Optimierungslöser auf einem Konvexe-Robuste-Parameter-Schätzung, CRPE, -Verfahren und einem Nicht-Konvexe-Robuste-Parameter-Schätzung, NRPE, -Verfahren basieren.

3. System nach Anspruch 1, wobei der Eingangszeitbereich eine Abtastperiode und eine Abtastfrequenz darstellt.

4. System nach Anspruch 1, wobei das Matrix-Pencil-Programm eingerichtet ist, Eigenwerte zu erhalten und den Dämpfungsfaktor und die Frequenz unter Verwendung der Eigenwerte zu berechnen.

5. System nach Anspruch 1, wobei die beschafften Signale Stromsignale oder Schwingungssignale sind, die auf Betrieben der elektrischen Maschine basieren.

6. System nach Anspruch 1, wobei die elektrische Maschine eine elektrische Schaltung, ein Elektromotor oder ein elektrischer Generator ist.

7. Verfahren zum Erfassen von Fehlern einer elektrischen Maschine während eines Betriebs der elektrischen Maschine, umfassend:

   Beschaffen von Signalen über Sensoren in Bezug auf die Maschine für einen Eingangszeitbereich;
   wobei das Verfahren **gekennzeichnet ist durch**:

   Erzeugen einer Signal-Hankel-Matrix auf der Grundlage der beschafften Signale für den Eingangszeitbereich;
   Bilden eines Optimierungsproblems mit einer Low-Rank-Beschränkung unter Verwendung eines Optimierungsbildungsprogramms, das ein Konvexe-Robuste-Parameter-Schätzung, CRPE, engl. convex robust parameter estimation, -Optimierungsproblem oder ein Nicht-Konvexe-Robuste-Parameter-Schätzung, NRPE, engl. non-convex robust parameter estimation, -Optimierungsproblem erzeugt;
   Entmischen der Signalmatrix in eine Low-Rank-Matrix, eine Spike-Interferenzmatrix und eine Gaußsche Rauschmatrix **durch** Lösen des Optimierungsproblems unter Verwendung eines der Optimierungslöser;
   Extrahieren von Parametern gedämpfter Exponentiale aus der Low-Rank-Matrix unter Verwendung des Matrix-Pencil-Programms; und
   Bestimmen der Fehler in Bezug auf die elektrische Maschine durch Identifizieren jedes gemessenen Systemparameters der elektrischen Maschine auf der Grundlage der Nachschlagedaten.

8. Verfahren nach Anspruch 7, wobei die Optimierungslöser auf einem Konvexe-Robuste-Parameter-Schätzung, CRPE, -Verfahren und einem Nicht-Konvexe-Robuste-Parameter-Schätzung, NRPE, -Verfahren basieren.

9. Verfahren nach Anspruch 7, wobei der Eingangszeitbereich eine Abtastperiode und eine Abtastfrequenz darstellt.

10. Verfahren nach Anspruch 7, wobei das Matrix-Pencil-Programm eingerichtet ist, Eigenwerte zu erhalten und den Dämpfungsfaktor und die Frequenz unter Verwendung der Eigenwerte zu berechnen.

11. Verfahren nach Anspruch 7, wobei die beschafften Signale Stromsignale oder Schwingungssignale sind, die auf Betrieben der elektrischen Maschine basieren.

12. Verfahren nach Anspruch 7, wobei die elektrische Maschine eine elektrische Schaltung, ein Elektromotor oder ein elektrischer Generator ist.


**Revendications**

1. Système de détection des défauts d'une machine électrique pendant le fonctionnement de la machine électrique, comprenant :

   une interface configurée pour acquérir des signaux via des capteurs relatifs à la machine pour un domaine temporel d'entrée ;
   une mémoire pour stocker des programmes mis en oeuvre par ordinateur comprenant un programme d'échantillonnage de signal, un programme de formation de matrice, un programme de formation d'optimisation, un programme de faisceau de matrices, des solveurs d'optimisation et des données de référence comprenant des paramètres de système prédéterminés associés aux défauts ; et
   un processeur configuré pour exécuter les programmes mis en oeuvre par ordinateur en relation avec l'interface et la mémoire, le système étant **caractérisé en ce que** le processeur est configuré pour effectuer :

      la génération d'une matrice de Hankel relative aux signaux fondée sur les signaux acquis pour le domaine temporel d'entrée ;
      la formation d'un problème d'optimisation avec une contrainte de rang faible à l'aide du programme de formation d'optimisation qui génère un problème d'optimisation de l'estimation robuste convexe des paramètres (CRPE) ou un problème d'optimisation de l'estimation robuste non convexe des paramètres (NRPE) ;
      la séparation de la matrice de signaux en une matrice de rang faible, une matrice de pointe de brouillage et une matrice de bruit gaussien par résolution du problème d'optimisation à l'aide de l'un des solveurs d'optimisation ;
      l'extraction de paramètres d'exponentielles amorties de la matrice de rang faible à l'aide du programme de faisceau de matrices ; et
      la détermination des défauts de la machine électrique par l'identification de chacun des paramètres de système mesurés de la machine électrique sur la base des données de référence.

2. Système selon la revendication 1, dans lequel les solveurs d'optimisation sont fondés sur un procédé d'estimation robuste convexe des paramètres (CRPE) et un procédé d'estimation robuste non convexe des paramètres (NRPE).

3. Système selon la revendication 1, dans lequel le domaine temporel d'entrée représente une période d'échantillonnage et une fréquence d'échantillonnage.

4. Système selon la revendication 1, dans lequel le programme de faisceau de matrices est configuré pour obtenir des valeurs propres et calculer le facteur d'amortissement et la fréquence à l'aide des valeurs propres.

5. Système selon la revendication 1, dans lequel les signaux acquis sont des signaux de courant ou des signaux de vibration fondés sur les opérations de la machine électrique.

6. Système selon la revendication 1, dans lequel la machine électrique est un circuit électrique, un moteur électrique ou un générateur électrique.

**7.** Procédé de détection des défauts d'une machine électrique pendant le fonctionnement de la machine électrique, comprenant :

l'acquisition de signaux via des capteurs relatifs à la machine pour un domaine temporel d'entrée ;
le procédé étant **caractérisé par** :

la génération d'une matrice de Hankel relative aux signaux fondée sur les signaux acquis pour le domaine temporel d'entrée ;
la formation d'un problème d'optimisation avec une contrainte de rang faible à l'aide d'un programme de formation d'optimisation qui génère un problème d'optimisation de l'estimation robuste convexe des paramètres (CRPE) ou un problème d'optimisation de l'estimation robuste non convexe des paramètres (NRPE) ;
la séparation de la matrice de signaux en une matrice de rang faible, une matrice de pointe de brouillage et une matrice de bruit gaussien par résolution du problème d'optimisation à l'aide de l'un des solveurs d'optimisation ;
l'extraction de paramètres d'exponentielles amorties de la matrice de rang faible à l'aide du programme de faisceau de matrices ; et
la détermination des défauts de la machine électrique par l'identification de chacun des paramètres de système mesurés de la machine électrique sur la base des données de référence.

**8.** Procédé selon la revendication 7, dans lequel les solveurs d'optimisation sont fondés sur un procédé d'estimation robuste convexe des paramètres (CRPE) et un procédé d'estimation robuste non convexe des paramètres (NRPE).

**9.** Procédé selon la revendication 7, dans lequel le domaine temporel d'entrée représente une période d'échantillonnage et une fréquence d'échantillonnage.

**10.** Procédé selon la revendication 7, dans lequel le programme de faisceau de matrices est configuré pour obtenir des valeurs propres et calculer le facteur d'amortissement et la fréquence à l'aide des valeurs propres.

**11.** Procédé selon la revendication 7, dans lequel les signaux acquis sont des signaux de courant ou des signaux de vibration fondés sur les opérations de la machine électrique.

**12.** Procédé selon la revendication 7, dans lequel la machine électrique est un circuit électrique, un moteur électrique ou un générateur électrique.

FIG.1A

# FIG.1B

**FIG.2**

```
   121              210              220              230

 ┌──────────┐   ┌──────────┐   ┌──────────┐   ┌──────────┐
 │          │   │ Form a   │   │ Denoise  │   │Determine │
 │  Noisy   │   │ Hankel   │   │ Hankel   │   │ damped   │
 │measure-  │──▶│matrix    │──▶│matrix    │──▶│ signal   │
 │ments     │   │from Noisy│   │using CRPE│   │parameters│
 │          │   │measure-  │   │or NRPE   │   │using a   │
 │          │   │ments     │   │          │   │ matrix   │
 │          │   │          │   │          │   │pencil    │
 └──────────┘   └──────────┘   └──────────┘   │method    │
                                              └──────────┘
```

Normal — N ◀── Magnitude > threshold? ◀── Search fault characteristic frequency of damped signal

270        250        240

Y → Detect fault   260

EP 4 118 502 B1

# FIG.3

**220**

EP 4 118 502 B1

---

**Algorithm 1 Solving CRPE via ADMM**

---

**Input:** $y, \lambda_1, \lambda_2, p, \mu,$ tol, MaxIter

1: **Initialization:** $Y = H(y,p), x_0 = 0, S_0 = Z_0 = V_0 = 0,$ $Loss_0 = 0$

2: **for** $k = 0, 1 \cdots ,$ MaxIter **do**

3:      Update $x$:

4:          $x_{k+1} = \frac{1}{1+\mu} \text{RevDM}(Y - S_k + \mu Z_k - V_k)$

5:      Update $Z$:

6:          $Z_{k+1} = \mathcal{D}_{\lambda_1 \mu^{-1}} \left( H(x_{k+1}, p) + \mu^{-1} V_k \right)$

7:      Update $S$:

8:          $S_{k+1} = \mathcal{S}_{\lambda_2} \left( Y - H(x_{k+1}, p) \right)$

9:      Update $V$:

10:          $V_{k+1} = V_k + \mu[H(x_{k+1}, p) - Z_{k+1}]$

11:      Calculate the Loss:

12:          $Loss_{k+1} = f_{CRPE}(x_{k+1}, S_{k+1})$

13:

14:      **if** $|Loss_{k+1} - Loss_k|/|Loss_{k+1}| \leq$ tol **then**

15:          *Break*

**Output:** $x_{k+1}, S_{k+1}$

---

**Algorithm 2 Solving NRPE via coordinate descent**

---

**Input:** $y, \lambda_2, p, r,$ tol, MaxIter

1: **Initialization:** $Y = H(y,p), x_0 = \hat{x}_0 = 0, S_0 = L_0 = 0,$ $Loss_0 = 0$

2: **for** $k = 0, 1 \cdots ,$ MaxIter **do**

3:      Update $\hat{x}$:

4:          $\hat{x}_{k+1} = \text{RevDM}(Y - S_k)$

5:      Project $H(\hat{x}_{k+1}, p)$ onto the low-rank space:

6:          $L_{k+1} = \mathcal{T}_r(H(\hat{x}_{k+1}, p))$

7:      Update $x$ by projecting $L_{k+1}$ onto the Hankel space:

8:          $x_{k+1} = \text{RevDM}(L_{k+1})$

9:      Update $S$:

10:          $S_{k+1} = \mathcal{S}_{\lambda_2} \left( Y - H(x_{k+1}, p) \right)$

11:      Calculate the Loss:

12:          $Loss_{k+1} = f_{NRPE}(x_{k+1}, S_{k+1})$

13:

14:      **if** $|Loss_{k+1} - Loss_k|/|Loss_{k+1}| \leq$ tol **then**

15:          *Break*

**Output:** $x_{k+1}, S_{k+1}, L_{k+1}$

---

# FIG.4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KANEMARU MAKOTO et al.** Bearing Fault Detection in Induction Machine Based on Stator Current Spectrum Monitoring. *IEEJ Journal of Industry Applications,* 01 May 2018, vol. 7 (3), 282-288